(19) Europäisches Patentamt
European Patent Office
Office européen des brevets

(11) **EP 4 678 707 A1**

(12) **EUROPEAN PATENT APPLICATION**
published in accordance with Art. 153(4) EPC

(43) Date of publication:
**14.01.2026 Bulletin 2026/03**

(21) Application number: **24797463.7**

(22) Date of filing: **26.04.2024**

(51) International Patent Classification (IPC):
*C09G 1/02* (2006.01)    *C09K 3/14* (2006.01)
*H01L 21/306* (2006.01)

(52) Cooperative Patent Classification (CPC):
**C09G 1/02; C09K 3/14; H01L 21/306**

(86) International application number:
**PCT/KR2024/005675**

(87) International publication number:
**WO 2024/225809 (31.10.2024 Gazette 2024/44)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **28.04.2023 KR 20230056015**

(71) Applicant: **SK enpulse Co., Ltd.
Seongnam-si, Gyeonggi-do 13453 (KR)**

(72) Inventors:
• **HAN, Deoksu
  Seoul 03142 (KR)**
• **HONG, Seungchul
  Seoul 03142 (KR)**

(74) Representative: **BCKIP Part mbB
MK1
Landsbergerstraße 98, 3.Stock
80339 München (DE)**

(54) **POLISHING COMPOSITION FOR SEMICONDUCTOR PROCESS, AND METHOD FOR POLISHING SUBSTRATE BY USING SAME**

(57)    A polishing composition for semiconductor process according to one embodiment of the present specification comprises polishing particles. An Rps value, which is a ratio of a micropore specific surface area to an external specific surface area of the polishing particles according to the following Formula 1, is 0.5 to 2.

[Formula 1]

$$Rps = \frac{Ap}{As}$$

In Formula 1, Ap is a micropore specific surface area of the polishing particles, and As is an external specific surface area of the polishing particles.
When such a polishing composition for semiconductor process is applied to a CMP polishing process, it may exhibit excellent polishing rate and may provide a polished surface with reduced defects.

EP 4 678 707 A1

[FIG. 1]

Diameter of secondary particles (nm)

**Description**

[Technical Field]

[Cross-Reference to Related Application]

This application claims priority from Korean Patent Application No. 10-2023-0056015, filed on April 28, 2023, and the contents of the above patent document are incorporated herein by reference in their entirety.

The present disclosure relates to a polishing composition for semiconductor process and a method for polishing a substrate using the same.

[Background Art]

As semiconductor devices become further miniaturized and highly integrated, finer pattern forming technologies are being used, and accordingly, the surface structure of semiconductor devices becomes more complicated and the step difference between interlayer films becomes larger. As a planarization technique for removing the step difference at a specific film formed on a substrate in manufacturing semiconductor devices, a chemical mechanical polishing (CMP) process is used.

In the CMP process, slurry is supplied to a polishing pad while the substrate is pressed and rotated, and the surface is polished. Depending on the process step, the target to be planarized changes, and the physical properties of the slurry applied also differ.

After metal wiring is formed, it is necessary to maintain sufficient polishing rate and polishing speed while minimizing dishing or erosion.

[Prior Art Documents]

[Patent Documents]

    (Patent Document 1) Korean Patent Publication No. 10-2017-0021320
    (Patent Document 2) Japanese Patent Publication No. H11-060232

[Detailed Description of the Invention]

[Technical Problem]

An object of the present disclosure is to provide a polishing composition for semiconductor process which, when applied to a CMP process, can exhibit excellent polishing rate and can realize a polished surface with reduced defects.

[Solution to the Problem]

A polishing composition for semiconductor process according to one embodiment of the present specification comprises polishing particles.

An Rps value, which is a ratio of a micropore specific surface area to an external specific surface area of the polishing particles according to the following Formula 1, is 0.5 to 2.

$$[\text{Formula 1}]$$

$$Rps = \frac{Ap}{As}$$

In Formula 1, Ap is the micropore specific surface area of the polishing particles, and As is the external specific surface area of the polishing particles.

The Ap value may be 25 $m^2$/g to 50 $m^2$/g.

The As value may be 10 $m^2$/g to 30 $m^2$/g.

A BET specific surface area of the polishing particles may be 30 $m^2$/g to 80 $m^2$/g.

A specific pore volume of the micropores of the polishing particles may be 0.011 cm$^3$/g to 0.2 cm$^3$/g.

An average diameter of the micropores of the polishing particles may be 15 nm to 40 nm.

The polishing particles may comprise secondary particles having a diameter of 120 nm or more in an amount of 10 wt% or less.

The polishing particles may comprise secondary particles having a diameter of less than 50 nm in an amount of 10 wt% or less.

The polishing composition for semiconductor process may comprise the polishing particles in an amount of 4 wt% to 12 wt%.

The polishing composition for semiconductor process may have a pH of 8 to 12.

A method for manufacturing a substrate according to another embodiment of the present specification comprises a process of polishing a substrate by applying, as a slurry, the polishing composition for semiconductor process.

Polishing particles according to still another embodiment of the present specification has an Rps value, which is a ratio of a micropore specific surface area to an external specific surface area of the polishing particles of Formula 1, is 0.5 to 2.

[Formula 1]

$$Rps = \frac{Ap}{As}$$

In Formula 1, Ap is the micropore specific surface area of the polishing particles, and As is the external specific surface area of the polishing particles.

The Ap value may be 25 m$^2$/g to 50 m$^2$/g.

The As value may be 10 m$^2$/g to 30 m$^2$/g.

A BET specific surface area of the polishing particles may be 30 m$^2$/g to 80 m$^2$/g. A specific pore volume of the micropores of the polishing particles may be 0.011 cm$^3$/g to 0.2 cm$^3$/g or less.

An average diameter of the micropores of the polishing particles may be 15 nm to 40 nm.

When the polishing particles are introduced into ultrapure water, the polishing particles may comprise secondary particles having a diameter of 120 nm or more in an amount of 10 wt% or less.

When the polishing particles are introduced into ultrapure water, the polishing particles may comprise secondary particles having a diameter of less than 50 nm in an amount of 10 wt% or less.

[Effect of the Invention]

The polishing composition for semiconductor process of the present disclosure, when applied to a CMP process, can exhibit excellent polishing rate and provide a polished surface with reduced defects.

[Brief Description of the Drawings]

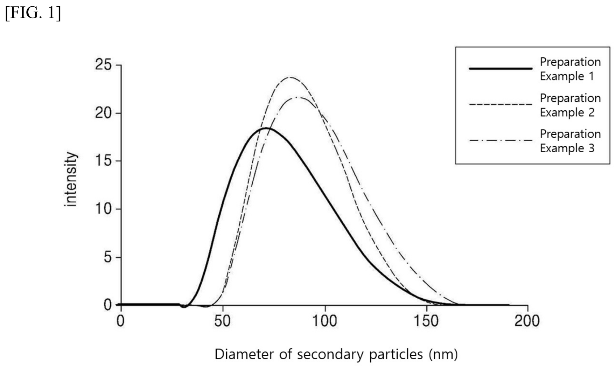

FIG. 1 is a graph showing the diameter distribution of secondary particles of polishing particles according to Preparation Examples.

[Mode for Carrying Out the Invention]

Hereinafter, embodiments will be described in detail with reference to embodiments so that those skilled in the art to which the present disclosure pertains can easily carry out the embodiments. However, the embodiments may be implemented in various different forms, and are not limited to the embodiments described herein.

In this specification, terms such as "about," "substantially," and the like, when presented with numerical values, are used in a sense proximate to the numerical values when considering inherent manufacturing and material tolerances, and are used to prevent unscrupulous infringers from unfairly taking advantage of the disclosure containing accurate or absolute values, and to aid in the understanding of the embodiments.

Throughout this specification, the term "a combination thereof" included in a Markush-type expression means a mixture or combination of one or more selected from the group consisting of elements listed in the Markush expression, and means including one or more selected from the group consisting of the elements.

Throughout this specification, the phrase "A and/or B" means "A, B, or A and B."

Throughout this specification, terms such as "first," "second," "A," "B" and the like are used to distinguish identical terms from each other unless otherwise specifically described.

In this specification, the phrase that B is located on A means that B is located on A, or that B is located on A while another layer is interposed therebetween, and it does not mean that B is necessarily in direct contact with the surface of A.

In this specification, singular expressions, unless otherwise specifically described, are interpreted to include both singular and plural as understood in context.

The inventors of the present disclosure experimentally confirmed that, when a polishing composition for semiconductor process in which an Rps value (ratio of micropore specific surface area to external specific surface area of polishing particles) and the like are controlled is applied to CMP polishing, the polishing composition can exhibit excellent polishing rate with respect to a target substrate to be polished, while effectively reducing the frequency of defect occurrence on the polished surface, and completed the present disclosure.

Hereinafter, the embodiments will be specifically described.

## Surface Characteristics of Polishing Particles

The polishing composition for semiconductor process according to the present disclosure comprises polishing particles.

An Rps value, which is a ratio of a micropore specific surface area to an external specific surface area of the polishing particles according to the following Formula 1, is 0.5 to 2.

[Formula 1]

$$Rps = \frac{Ap}{As}$$

In Formula 1, Ap is the micropore specific surface area of the polishing particles, and As is the external specific surface area of the polishing particles.

The term "micropore" means a pore having a diameter of less than 2 nm.

The present disclosure controls the Rps value of polishing particles so as to adjust the degree of irregularity in the shape of the polishing particles and to impart a certain level of roughness to the surface of the polishing particles. Polishing particles having such characteristics may exhibit a wider contact area with the surface to be polished when polishing pressure is applied during a CMP process compared with spherical particles having a smooth surface, thereby providing a superior polishing rate for the surface to be polished. At the same time, since the degree of micropore formation on the surface of the polishing particles is controlled, the durability of the polishing particles can be stably controlled. This makes it possible to effectively reduce the frequency of defect occurrence on the polished surface caused by damaged polishing particles during polishing.

Method for Measuring Rps Value of Polishing Particles is described as follows.

Polishing particles are degassed at 250°C for 3 hours. The degassed polishing particles are introduced into a specific surface area measuring device, nitrogen adsorption amount onto the polishing particles is measured while relative pressure (p/p°) is increased from 0 to 1.0 at 77.3K, and nitrogen desorption amount from the polishing particles is measured while relative pressure is decreased from 1.0 to 0, thereby obtaining an adsorption/desorption isotherm of nitrogen of the polishing particles. The specific surface area value of the polishing particles is calculated from the adsorption/desorption isotherm of nitrogen by the BET (Brunauer-Emmett-Teller) method, and the value is defined as a BET specific surface area of the polishing particles.

Here, p is the equilibrium pressure of nitrogen gas, and p° is the saturated vapor pressure of nitrogen gas.

A t-plot is generated from the adsorption/desorption isotherm of nitrogen according to the Harkins-Jura equation, and an external specific surface area value (As) of the polishing particles is calculated. Thereafter, a value obtained by subtracting the As value from the BET specific surface area value of the polishing particles is defined as the Ap value.

The Rps value is calculated by dividing the Ap value by the As value.

As an example, a TriStar II 3020 model manufactured by Micromeritics may be applied as the specific surface area measuring instrument.

The Rps value of the polishing particles may be 0.5 to 2. The Rps value may be 0.7 or more. The Rps value may be 0.9 or more. The Rps value may be 1.8 or less. The Rps value may be 1.5 or less. In this case, while enhancing the polishing rate of the polishing composition for a target substrate, the defect occurrence caused by the polishing particles can be effectively suppressed.

The Ap value may be 25 $m^2$/g to 50 $m^2$/g. The Ap value may be 26 $m^2$/g or more. The Ap value may be 27 $m^2$/g or more. The Ap value may be 40 $m^2$/g or less. The Ap value may be 35 $m^2$/g or less. The Ap value may be 32 $m^2$/g or less. In this case, appropriate roughness may be imparted to the surface of the polishing particles to improve the polishing efficiency of the polishing composition.

The As value may be 10 m$^2$/g to 30 m$^2$/g. The As value may be 15 m$^2$/g or more. The As value may be 20 m$^2$/g or more. The As value may be 22 m$^2$/g or more. The As value may be 28 m$^2$/g or less. The As value may be 26 m$^2$/g or less. In this case, the polishing composition may simultaneously exhibit improved polishing rate and stable durability.

The specific surface area of the polishing particles may be influenced not only by the shape of the polishing particles but also by the size of the polishing particles. Specifically, the specific surface area of the polishing particles tends to increase as the size of the polishing particles decreases. The present disclosure may control parameter values related to the specific surface area of the polishing particles so that both particle size distribution and shape of the polishing particles may be appropriately controlled within a proper range.

The BET specific surface area of the polishing particles may be 30 m$^2$/g to 80 m$^2$/g. The BET specific surface area may be 40 m$^2$/g or more. The BET specific surface area may be 45 m$^2$/g or more. The BET specific surface area may be 48 m$^2$/g or more. The BET specific surface area may be 70 m$^2$/g or less. The BET specific surface area may be 65 m$^2$/g or less. The BET specific surface area may be 60 m$^2$/g or less. In this case, while reducing the frequency of occurrence of defects formed by small-sized polishing particles being adsorbed on the polished surface, polishing characteristics of the polishing composition may be effectively improved.

The present disclosure may control structural characteristics of micropores inside the polishing particles. Polishing particles having such characteristics may have irregular shapes while maintaining stable durability.

The specific pore volume of micropores of the polishing particles may be 0.011 cm$^3$/g to 0.2 cm$^3$/g. The specific pore volume may be 0.012 cm$^3$/g or more. The specific pore volume may be 0.15 cm$^3$/g or less. The specific pore volume may be 0.1 cm$^3$/g or less. The specific pore volume may be 0.05 cm$^3$/g or less. The specific pore volume may be 0.03 cm$^3$/g or less. The specific pore volume may be 0.02 cm$^3$/g or less. In this case, damage to the polishing particles by polishing pressure may be suppressed, and defects occurring due to particles derived from the polishing particles being adsorbed onto the polished surface may be suppressed.

The average diameter of micropores of the polishing particles may be 15 nm to 40 nm. The average diameter may be 18 nm or more. The average diameter may be 20 nm or more. The average diameter may be 35 nm or less. The average diameter may be 30 nm or less. The average diameter may be 28 nm or less. In this case, the polishing particles may not easily break by external force and may have a more stable structure.

The specific pore volume and the average diameter of micropores are measured through a specific surface area measuring instrument. The specific measuring conditions applied for measuring the specific pore volume and the average diameter of micropores are the same as those applied in measuring the BET specific surface area.

## Diameter distribution of the polishing particles

The polishing particles may comprise secondary particles having a diameter of 120 nm or more in an amount of 10 wt% or less. The polishing particles may comprise secondary particles having a diameter of 120 nm or more in an amount of 8 wt% or less. The polishing particles may comprise secondary particles having a diameter of 120 nm or more in an amount of 0.1 wt% or more. In this case, scratches formed on the polished surface due to large-diameter secondary particles during polishing may be effectively suppressed.

The polishing particles may comprise secondary particles having a diameter of less than 50 nm in an amount of 10 wt% or less. The polishing particles may comprise secondary particles having a diameter of less than 50 nm in an amount of 8 wt% or less. The polishing particles may comprise secondary particles having a diameter of less than 50 nm in an amount of 0.1 wt% or more. In this case, the frequency of relatively small-sized particles among the polishing particles being adsorbed onto the polished surface due to interaction with the polished surface may be reduced.

The $D_{50}$ of the secondary particles of the polishing particles may be 40 nm or more. The $D_{50}$ may be 45 nm or more. The $D_{50}$ may be 50 nm or more. The $D_{50}$ may be 55 nm or more. The $D_{50}$ may be 100 nm or less. The $D_{50}$ may be 95 nm or less. The $D_{50}$ may be 90 nm or less. The $D_{50}$ may be 85 nm or less. The $D_{50}$ may be 80 nm or less. In this case, while stably controlling the occurrence of defects on the polished surface, excellent polishing characteristics may be imparted to the polishing composition.

The diameter of secondary particles of the polishing particles is measured through DLS (Dynamic Light Scattering). As an example, the diameter of the secondary particles of the polishing particles was measured using a particle size analyzer, Zetasizer nano-ZS model, manufactured by Malvern Panalytical.

The $D_{50}$ of the primary particles of the polishing particles may be 15 nm or more. The $D_{50}$ may be 20 nm or more. The $D_{50}$ may be 25 nm or more. The $D_{50}$ may be 55 nm or less. The $D_{50}$ may be 50 nm or less. The $D_{50}$ may be 45 nm or less. In this case, while stably reducing the frequency of defects occurring by polishing particles being adsorbed on the polished surface, the polishing composition may exhibit excellent polishing characteristics.

The diameter of the primary particles of the polishing particles is measured through TEM (Transmission Electron Microscope).

The degree of aggregation of the polishing particles may be 3 or less. The degree of aggregation may be 2.8 or less. The degree of aggregation may be 2.5 or less. The degree of aggregation may be 2.3 or less. The degree of aggregation may be 1.1 or more. The degree of aggregation may be 1.5 or more. In this case, the polishing composition may exhibit stable reproducibility of polishing characteristics and polishing rate.

The degree of aggregation of the polishing particles is measured by a method generally applied in the CMP slurry field.

## Composition of Polishing Particles

The polishing particles may comprise metal oxide particles. The polishing particles may comprise silica. The polishing particles may comprise colloidal silica.

The polishing particles may comprise colloidal silica in an amount of 70 wt% or more. The polishing particles may comprise colloidal silica in an amount of 80 wt% or more. The polishing particles may comprise colloidal silica in an amount of 90 wt% or more. The polishing particles may be colloidal silica.

The polishing particles may comprise alkali metals in an amount of 1000 ppb (based on weight) or less. The polishing particles may comprise alkali metals in an amount of 800 ppb (based on weight) or less. The polishing particles may comprise alkali metals in an amount of 600 ppb (based on weight) or less. The polishing particles may comprise alkali metals in an amount of 400 ppb (based on weight) or less. The polishing particles may comprise alkali metals in an amount of 50 ppb (based on weight) or more.

The polishing particles may comprise heavy metals in an amount of 500 ppb (based on weight) or less. The polishing particles may comprise heavy metals in an amount of 400 ppb (based on weight) or less. The polishing particles may comprise heavy metals in an amount of 300 ppb (based on weight) or less. The polishing particles may comprise heavy metals in an amount of 200 ppb (based on weight) or less. The polishing particles may comprise heavy metals in an amount of 10 ppb (based on weight) or more.

In such a case, when polishing a target substrate in which wiring is exposed, it may effectively prevent metallic impurities from being adsorbed or remaining on the polished surface, thereby preventing electrical defects such as insulation failure of circuits or short-circuiting of wiring.

## Composition and Physical Properties of Polishing Composition for Semiconductor Process

The polishing composition for semiconductor process may comprise the polishing particles in an amount of 4 wt% to 12 wt%. The polishing composition for semiconductor process may comprise the polishing particles in an amount of 6 wt% or more. The polishing composition for semiconductor process may comprise the polishing particles in an amount of 10 wt% or less. In such a polishing composition, the polishing particles may be stably dispersed in the composition, and may help reduce the frequency of defect occurrence during the polishing process.

The polishing composition for semiconductor process may further comprise an additive. The additive is not limited as long as it is conventionally applied in the CMP field. For example, the additive may be at least one selected from the group consisting of a nonionic polymer, a chelating agent, an oxidizing agent, an acid component, a pH adjuster, a dispersant, a polishing rate enhancer, a polishing controller, a polishing pad protector, and a preservative.

The polishing composition for semiconductor process may further comprise a nonionic polymer to further improve the dispersibility of the polishing particles in the polishing composition. Specifically, the nonionic polymer included in the polishing composition may be adsorbed onto the polishing particles to increase the dispersibility of the polishing particles. In addition, the nonionic polymer not adsorbed onto the polishing particles may have steric hindrance effects and the like, thereby further enhancing the dispersion stability of the polishing particles. In particular, the nonionic polymer may allow the polishing composition for semiconductor process to have more stable dispersion stability even in an acidic environment. Such a nonionic polymer may reduce the occurrence of defects caused by polishing on the substrate during the polishing process.

The nonionic polymer may be at least one selected from the group consisting of polyethylene glycol, polypropylene glycol, polyvinylpyrrolidone, polyethylene oxide, polypropylene oxide, polyalkylene oxide, polyoxyethylene oxide, polyethylene oxide-propylene oxide copolymer, cellulose, methylcellulose, methylhydroxyethylcellulose, methylhydroxypropylcellulose, hydroxyethylcellulose, carboxymethylcellulose, carboxymethylhydroxyethylcellulose, sulfoethylcellulose, and carboxymethylsulfoethylcellulose.

The nonionic polymer may have a weight average molecular weight of less than 25,000 g/mol. The weight average molecular weight may be 1,000 g/mol or more and less than 25,000 g/mol. In such a case, the nonionic polymer may exhibit excellent solubility and further improve the dispersion stability of the polishing particles.

The polishing composition for semiconductor process may comprise the nonionic polymer in an amount of 0.01 wt% to 5 wt%. The polishing composition for semiconductor process may comprise the nonionic polymer in an amount of 0.1 wt% or more. The polishing composition for semiconductor process may comprise the nonionic polymer in an amount of 2 wt% or less. In such a case, the polishing composition may help reduce the frequency of defect occurrence on the surface of the polished substrate, and may suppress contamination such as reattachment of particles on the surface.

The polishing composition for semiconductor process may further comprise a chelating agent. Through the polishing process, metals or metal ions removed from the surface of the substrate may be reattached or remain on the substrate surface to form defects. In particular, metals such as tungsten may be easily dissolved in the polishing composition under specific conditions, but may have characteristics that are easily attached to the polished surface. The chelating agent may be adsorbed to such metals or metal ions, thereby easily removing the metals and the like. Through this, the polishing composition may further increase the polishing rate and may effectively suppress defect formation on the substrate surface due to particle reattachment.

For example, the chelating agent may be at least one selected from the group consisting of butyric acid, citric acid, tartaric acid, succinic acid, oxalic acid, acetic acid, adipic acid, capric acid, caproic acid, caprylic acid, carboxylic acid, glutaric acid, glutamic acid, glycolic acid, thioglycolic acid, formic acid, mandelic acid, fumaric acid, lactic acid, lauric acid, malic acid, maleic acid, malonic acid, myristic acid, palmitic acid, phthalic acid, isophthalic acid, terephthalic acid, citraconic acid, propionic acid, pyruvic acid, stearic acid, valeric acid, benzoic acid, phenylacetic acid, naphthoic acid, aspartic acid, amino acid, and ethylenediaminetetraacetic acid.

As the amino acid, glycine, $\alpha$-alanine, $\beta$-alanine, L-aspartic acid, N-methylglycine (methylglycine), and combinations thereof may be applied.

The chelating agent may comprise 2 or more carboxyl groups or alcohol groups in the molecule. Two or more kinds of chelating agents comprising 2 or more carboxyl groups or alcohol groups in the molecule may be applied. Specifically, the chelating agent may comprise at least one selected from the group consisting of EDTA (ethylenediaminetetraacetic acid), glycine, carboxylic acids, and combinations thereof. The carboxylic acids mean compounds comprising at least one or two or more carboxyl groups in each molecule.

The polishing composition for semiconductor process may comprise the chelating agent in an amount of 0.003 wt% to 0.5 wt%. The polishing composition for semiconductor process may comprise the chelating agent in an amount of 0.005 wt% or more. The polishing composition for semiconductor process may comprise the chelating agent in an amount of 0.3 wt% or less. In such a case, the polishing rate of the polishing composition may be controlled to an appropriate level, and the frequency of defect occurrence on the surface of the substrate may be reduced.

The polishing composition for semiconductor process may further comprise an oxidizing agent. The oxidizing agent may oxidize metals such as tungsten to create an environment that allows the substrate surface to be more easily planarized, and may play a role in improving the polishing rate and the etching rate.

The oxidizing agent may be at least one selected from the group consisting of hydrogen peroxide, urea hydrogen peroxide, urea, percarbonate, periodic acid, periodate, perchloric acid, perchlorate, perbromic acid, perbromate, perboric acid, perborate, permanganic acid, permanganate, persulfate, bromate, chlorate, chlorite, chromate, iodate, iodine acid, ammonium persulfate, benzoyl peroxide, calcium peroxide, barium peroxide, sodium peroxide, and percarbamide.

The polishing composition for semiconductor process may comprise the oxidizing agent in an amount of 0.01 wt% to 5 wt%. In such a case, the composition may exhibit excellent polishing properties for metals, and may suppress the formation of an oxide film on the metal to be polished during the polishing process.

The polishing composition for semiconductor process may further comprise a copper corrosion inhibitor. The copper corrosion inhibitor may comprise an azole-based compound.

The azole-based compound may comprise one selected from the group consisting of benzotriazole (BTA), 5-methyl-1H-benzotriazole (5-MBTA), 3-amino-1,2,4-triazole, 5-phenyl-1H-tetrazole, 3-amino-5-methyl-4H-1,2,4-triazole, 5-aminotetrazole (ATZ), 1,2,4-triazole, tolyltriazole, and combinations thereof.

The azole-based compound may comprise one selected from the group consisting of 5-aminotetrazole (ATZ), 5-methyl-1H-benzotriazole (5-MBTA), and combinations thereof.

The azole-based compound may act on the copper surface during the polishing process to play a role in preventing copper corrosion.

The azole-based compound may be comprised in an amount of 0.02 to 2.00 parts by weight, 0.03 to 1.5 parts by weight, or 0.5 to 1.5 parts by weight, based on 100 parts by weight of the polishing particles.

In such a range, when comprising the azole-based compound, the polishing composition for semiconductor process may obtain the effect of preventing corrosion of the copper surface, and in particular, may provide a strong corrosion prevention effect on relatively large surfaces such as via hole surfaces.

The polishing composition for semiconductor process may further comprise an acid component. The acid component may be at least one selected from the group consisting of hydrochloric acid, phosphoric acid, sulfuric acid, hydrofluoric acid, bromic acid, iodic acid, formic acid, malonic acid, maleic acid, oxalic acid, acetic acid, adipic acid, citric acid, adipic acid, acetic acid, propionic acid, fumaric acid, lactic acid, salicylic acid, pimelic acid, benzoic acid, succinic acid, phthalic acid, butyric acid, glutaric acid, glutamic acid, glycolic acid, lactic acid, aspartic acid, tartaric acid, or salts thereof.

The polishing composition for semiconductor process may further comprise a pH adjuster together with the acid component. The pH adjuster may be one selected from the group consisting of ammonia, aminomethylpropanol, tetramethylammonium hydroxide, potassium hydroxide, sodium hydroxide, magnesium hydroxide, rubidium hydroxide, cesium hydroxide, sodium bicarbonate, sodium carbonate, imidazole, and combinations thereof.

The polishing composition for semiconductor process may further comprise a dispersant.

The dispersant may prevent aggregation between polishing particles in the polishing composition and may uniformly disperse the particles. The cationic dispersant may increase the zeta potential of the polishing composition to a positive value, and the anionic dispersant may decrease the zeta potential of the polishing composition to a negative value.

The dispersant may comprise an anionic low-molecular compound, a cationic polymer, and an organic acid.

The anionic low-molecular compound of the dispersant may be one selected from oxalic acid, citric acid, polysulfonic acid, polyacrylic acid, polymethacrylic acid, and combinations thereof.

The cationic polymer of the dispersant may be one selected from polylysine, polyethyleneimine, benzethonium chloride, bronidox, cetrimonium bromide, cetrimonium chloride, dimethyldioctadecyl ammonium chloride, tetramethylammonium hydroxide, distearyldimethyl ammonium chloride, polyaryl amine, and combinations thereof.

The organic acid of the dispersant may be one selected from hydroxybenzoic acid, ascorbic acid, picolinic acid, glutamic acid, tryptophan, aminobutyric acid, and combinations thereof.

The polishing rate enhancer may be an additive for increasing the polishing rate of the target substrate or wiring, and may be one selected from potassium nitrate, ferric nitrate, ammonium hydroxide, citric acid, acetic acid, and combinations thereof.

The polishing controller may be for minimizing adsorption of the polishing composition on the metal surface, and may comprise ammonium compounds, potassium nitrate, amino acids, salts thereof, or the like.

The polishing composition for semiconductor process may comprise a solvent. The solvent may be water, and specifically, may be ultrapure water.

The polishing composition for semiconductor process may have a pH of 8 to 12. The pH may be 9 or more. The pH may be 11 or less. In such a case, the dispersibility of the polishing particles and the polymer comprised in the polishing composition may be stably controlled. In addition, it may contribute to effectively suppressing defect occurrence on the polished surface caused by adsorption of polishing particles.

The polishing composition for semiconductor process may have a zeta potential of -80 mV to -20 mV. The zeta potential value may be -75 mV or more. The zeta potential value may be -70 mV or more. The zeta potential value may be -65 mV or more. The zeta potential value may be -60 mV or more. The zeta potential value may be -25 mV or less. The zeta potential value may be -30 mV or less. The zeta potential value may be -35 mV or less. The zeta potential value may be -40 mV or less. In such a case, the polishing particles may be stably dispersed in the polishing composition. In addition, the frequency of defect occurrence such as scratches on the polished surface caused by the polishing particles may be effectively reduced.

The zeta potential value of the polishing composition may be measured using a zeta potential measuring instrument.

**Polishing Characteristics of the Polishing Composition for Semiconductor Process**

The polishing rate of the polishing composition for semiconductor process for the silicon oxide film may be 1350 Å/min or more. The polishing rate may be 1450 Å/min or more. The polishing rate may be 1550 Å/min or more. The polishing rate may be 1650 Å/min or more. The polishing rate may be 3500 Å/min or less. The polishing rate may be 3000 Å/min or less. The polishing rate may be 2500 Å/min or less.

The $PI_S$ value of the polishing composition for semiconductor process according to the following Formula 2-1 may be 200 Å/(min·wt%) or more.

$$[\text{Formula 2-1}]$$

$$PI_S = \frac{P_S}{C}$$

In Formula 2-1, $P_S$ is the polishing rate of the polishing composition for semiconductor process for the silicon oxide film [unit: Å/min].

C is the content of the polishing particles in the polishing composition for semiconductor process [unit: wt%].

The $PI_S$ value may be 200 Å/(min·wt%) or more. The $PI_S$ value may be 210 Å/(min·wt%) or more. The $PI_S$ value may be 220 Å/(min·wt%) or more. The $PI_S$ value may be 300 Å/(min·wt%) or less.

The polishing rate of the polishing composition for semiconductor process for the barrier film comprising tantalum and tantalum nitride may be 780 Å/min or more. The polishing rate may be 800 Å/min or more. The polishing rate may be 830 Å/min or more. The polishing rate may be 1200 Å/min or less.

The $PI_T$ value of the polishing composition for semiconductor process according to the following Formula 2-2 may be 200 Å/(min·wt%) or more.

[Formula 2-2]

$$PI_T = \frac{P_T}{C}$$

In Formula 2-2, $P_T$ is the polishing rate of the polishing composition for semiconductor process for the barrier film comprising tantalum and tantalum nitride [unit: Å/min].

C is the content of the polishing particles in the polishing composition for semiconductor process [unit: wt%].

The $PI_T$ value may be 80 Å/(min·wt%) or more. The $PI_T$ value may be 85 Å/(min·wt%) or more. The $PI_T$ value may be 90 Å/(min·wt%) or more. The $PI_T$ value may be 95 Å/(min·wt%) or more. The $PI_T$ value may be 100 Å/(min·wt%) or more. The $PI_T$ value may be 200 Å/(min·wt%) or less.

The polishing rate of the polishing composition for semiconductor process for the copper film may be 850 Å/min or more. The polishing rate may be 900 Å/min or more. The polishing rate may be 950 Å/min or more. The polishing rate may be 1000 Å/min or more. The polishing rate may be 1050 Å/min or more. The polishing rate may be 1100 Å/min or more. The polishing rate may be 2500 Å/min or less.

The $PI_C$ value of the polishing composition for semiconductor process according to the following Formula 2-3 may be 100 Å/(min·wt%) or more.

[Formula 2-3]

$$PI_C = \frac{P_C}{C}$$

In Formula 2-3, $P_C$ is the polishing rate of the polishing composition for semiconductor process for the copper film [unit: Å/min].

C is the content of the polishing particles in the polishing composition for semiconductor process [unit: wt%].

The $PI_C$ value may be 110 Å/(min·wt%). The $PI_C$ value may be 120 Å/(min·wt%) or more. The $PI_C$ value may be 130 Å/(min·wt%) or more. The $PI_C$ value may be 140 Å/(min·wt%) or more. The $PI_C$ value may be 250 Å/(min·wt%) or less. The $PI_C$ value may be 200 Å/(min·wt%) or less.

In such a case, the polishing composition may exhibit excellent polishing rate for the target substrate in which the wiring, oxide film, and barrier film are simultaneously exposed.

The polishing rate for each thin film is measured under the conditions of a pressure of 2.2 psi, a carrier speed of 87 rpm, a platen speed of 93 rpm, and a slurry flow rate of 250 ml/min.

When measuring the polishing rate for each thin film, the polishing equipment may be, for example, the AP-300 model of CTS Co.

## Manufacturing Method of the Polishing Composition for Semiconductor Process

The manufacturing method of the polishing composition for semiconductor process according to the present disclosure may comprise a polishing particle forming step of preparing polishing particles, and a manufacturing step of preparing the polishing composition for semiconductor process comprising the polishing particles.

The polishing particle forming step may comprise a preparation process of preparing a first polishing particle manufacturing composition and a second polishing particle manufacturing composition, and a reaction process of obtaining the polishing particles from a reaction solution obtained by mixing the first polishing particle manufacturing composition and the second polishing particle manufacturing composition.

In the preparation process, the first polishing particle composition may comprise an organic silicon compound and a first organic solvent.

The organic silicon compound may be an alkoxy silane-based compound. The organic silicon compound may be, for example, TEOS (tetraethoxysilane) or TMOS (tetramethoxysilane).

The first organic solvent may be, for example, ethanol, methanol, or isopropyl alcohol.

The first polishing particle composition may comprise 20 parts by weight to 50 parts by weight of the organic silicon compound based on 100 parts by weight of the first organic solvent. The first polishing particle composition may comprise 25 parts by weight or more of the organic silicon compound based on 100 parts by weight of the first organic solvent. The first polishing particle composition may comprise 45 parts by weight or less of the organic silicon compound based on 100 parts by weight of the first organic solvent.

The first polishing particle composition may be prepared by mixing the organic silicon compound in the first organic solvent in a double-jacket reactor. However, the method of preparing the first polishing particle composition is not limited thereto.

The second polishing particle composition may comprise water, a catalyst, and a second organic solvent.

The second polishing particle composition may comprise 1 part by weight to 15 parts by weight of water based on 100 parts by weight of the second organic solvent. The second polishing particle composition may comprise 3 parts by weight or more of water based on 100 parts by weight of the second organic solvent. The second polishing particle composition may comprise 10 parts by weight or less of water based on 100 parts by weight of the second organic solvent.

The catalyst may participate in hydrolysis and polymerization reactions of the organic silicon compound during the reaction process, thereby contributing to controlling the shape and particle size distribution of the polishing particles.

The catalyst may be at least one selected from potassium hydroxide, sodium hydroxide, ammonia, TMAH (tetramethylammonium hydroxide), or TEA (triethanolamine).

The second polishing particle composition may comprise 0.5 parts by weight or more of the catalyst based on 100 parts by weight of the second organic solvent. The second polishing particle composition may comprise 1 part by weight or more of the catalyst based on 100 parts by weight of the second organic solvent. The second polishing particle composition may comprise 10 parts by weight or less of the catalyst based on 100 parts by weight of the second organic solvent. The second polishing particle composition may comprise 7 parts by weight or less of the catalyst based on 100 parts by weight of the second organic solvent.

The second organic solvent may be, for example, ethanol, methanol, or isopropyl alcohol. The second organic solvent may be the same compound as the first organic solvent.

In the reaction process, the first polishing particle manufacturing composition and the second polishing particle manufacturing composition may be mixed to prepare a reaction solution. To prepare the reaction solution, the second polishing particle manufacturing composition may be added to the first polishing particle manufacturing composition, or the first polishing particle manufacturing composition may be added to the second polishing particle manufacturing composition. Specifically, the first polishing particle manufacturing composition may be added to the second polishing particle manufacturing composition.

In the reaction process, the polishing particles may be obtained through hydrolysis and polymerization reactions of the organic silicon compound. The present disclosure may control the contents of each component in the reaction solution and the reaction temperature and the like, to adjust the shape characteristics and particle size distribution of the polishing particles obtained within a predetermined range set in the present disclosure.

In the reaction process, the reaction solution may comprise 60 parts by weight to 120 parts by weight of the second polishing particle manufacturing composition based on 100 parts by weight of the first polishing particle manufacturing composition. The reaction solution may comprise 65 parts by weight or more of the second polishing particle manufacturing composition based on 100 parts by weight of the first polishing particle manufacturing composition. The reaction solution may comprise 70 parts by weight or more of the second polishing particle manufacturing composition based on 100 parts by weight of the first polishing particle manufacturing composition. The reaction solution may comprise 100 parts by weight or less of the second polishing particle manufacturing composition based on 100 parts by weight of the first polishing particle manufacturing composition.

The reaction solution may comprise 3 parts by weight or more of water based on 100 parts by weight of the organic silicon compound. The reaction solution may comprise 5 parts by weight or more of water based on 100 parts by weight of the organic silicon compound. The reaction solution may comprise 10 parts by weight or more of water based on 100 parts by weight of the organic silicon compound. The reaction solution may comprise 50 parts by weight or less of water based on 100 parts by weight of the organic silicon compound. The reaction solution may comprise 30 parts by weight or less of water based on 100 parts by weight of the organic silicon compound. The reaction solution may comprise 20 parts by weight or less of water based on 100 parts by weight of the organic silicon compound.

The reaction solution may comprise 1 part by weight or more of the catalyst based on 100 parts by weight of the organic silicon compound. The reaction solution may comprise 3 parts by weight or more of the catalyst based on 100 parts by weight of the organic silicon compound. The reaction solution may comprise 4 parts by weight or more of the catalyst based on 100 parts by weight of the organic silicon compound. The reaction solution may comprise 20 parts by weight or less of the catalyst based on 100 parts by weight of the organic silicon compound. The reaction solution may comprise 15 parts by weight or less of the catalyst based on 100 parts by weight of the organic silicon compound. The reaction solution may comprise 13 parts by weight or less of the catalyst based on 100 parts by weight of the organic silicon compound.

In such a case, the polishing particles having the shape characteristics and particle size distribution intended by the present disclosure may be obtained.

In the reaction process, the reaction temperature may be set to 20°C to 60°C. The reaction temperature may be 30°C or more. The reaction temperature may be 40°C or more. The reaction temperature may be 55°C or less. In such a case, the synthesis of the polishing particles may be smoothly carried out.

In the reaction process, the reaction time may be 2 hours to 10 hours. The reaction time may be 3 hours or more. The reaction time may be 4 hours or more. The reaction time may be 8 hours or less. The reaction time may be 7 hours or less. In such a case, the polishing particles may contribute to having the size and shape intended by the present disclosure.

The polishing particles may be prepared by reacting a silicate-based precursor and an alkoxy silane-based precursor.

The descriptions of the surface characteristics, diameter distribution, and composition of the polishing particles are omitted since they overlap with the previous descriptions.

In the manufacturing step, the polishing particles and a solvent may be mixed to prepare the polishing composition for semiconductor process. The polishing composition for semiconductor process may further comprise an additive together with the polishing particles and the solvent after purification.

The descriptions of the composition and physical properties of the polishing composition for semiconductor process are omitted since they overlap with the previous descriptions.

## Method for Manufacturing a Substrate

The method for manufacturing a substrate of the present disclosure may comprise a process of polishing the substrate by applying the polishing composition for semiconductor process as a slurry.

The substrate may comprise at least one of an insulating film, a metal wiring, or a barrier layer on an upper surface. The metal wiring may comprise copper or tungsten. When the metal wiring comprises copper, the barrier layer may comprise tantalum and nitrides thereof. When the metal wiring comprises tungsten, the barrier layer may comprise titanium and nitrides thereof.

Specifically, the process of polishing the substrate may be carried out such that the substrate to be polished is brought into contact with a polishing pad together with the polishing composition for semiconductor process supplied from a spray nozzle, while a polishing head fixing the substrate rotates and a platen with the polishing pad attached also rotates.

The process of polishing the substrate may further comprise, as necessary, a conditioning process of conditioning the surface of the polishing pad before polishing.

The polishing composition for semiconductor process may penetrate toward the substrate and polish the wafer being in contact with the polishing pad.

In the process of polishing the substrate, a pressure of 6.89 kPa to 48.26 kPa may be applied. The pressure may be 13.79 kPa to 34.47 kPa.

The process of polishing the substrate may be carried out for 50 seconds to 10 minutes. However, it may be changed depending on the intended degree of polishing.

The descriptions of the polishing composition for semiconductor process are omitted since they overlap with the previous descriptions.

The method for manufacturing a substrate may further comprise a cleaning process of cleaning the substrate after polishing.

The cleaning process may be carried out by cleaning the polished substrate with purified water and inert gas.

## Polishing Particles

The polishing particles according to the present disclosure have an Rps value, which is a ratio of a micropore specific surface area to an external specific surface area according to the following Formula 1, of 0.5 to 2.

[Formula 1]

$$Rps = \frac{Ap}{As}$$

In Formula 1, Ap is the micropore specific surface area of the polishing particles, and As is the external specific surface area of the polishing particles.

The Ap value may be 25 m²/g to 50 m²/g.

The As value may be 10 m²/g to 30 m²/g.

The BET specific surface area of the polishing particles may be 30 m²/g to 80 m²/g.

The specific pore volume of the micropores of the polishing particles may be 0.011 cm³/g to 0.2 cm³/g or less.

The average diameter of the micropores of the polishing particles may be 15 nm to 40 nm.

When the polishing particles are introduced into ultrapure water, the polishing particles may comprise secondary particles having a diameter of 120 nm or more in an amount of 10 wt% or less.

When the polishing particles are introduced into ultrapure water, the polishing particles may comprise secondary particles having a diameter of less than 50 nm in an amount of 10 wt% or less.

The polishing particles are the same particles as the polishing particles described above. The descriptions of the surface characteristics, particle size distribution, composition, and manufacturing method of the polishing particles are omitted since they overlap with the previous descriptions.

Hereinafter, specific embodiments will be described in more detail. The following embodiments are merely examples provided to aid in understanding the present invention, and the scope of the present invention is not limited thereto.

**Preparation Example: Manufacture of Polishing Particles**

Preparation Example 1: In a first double-jacket reactor, 15 parts by weight of an organic silicon compound were mixed with 41 parts by weight of a first organic solvent to prepare a total of 56 parts by weight of a first polishing particle preparation composition. In a second double-jacket reactor, 1 part by weight of a catalyst and 2 parts by weight of water were introduced into 41 parts by weight of a second organic solvent to prepare a total of 44 parts by weight of a second polishing particle preparation composition. The temperature of the second double-jacket reactor was set to 45°C, and the first polishing particle preparation composition was introduced into the second polishing particle preparation composition, and a hydrolysis and polymerization reaction was carried out for 5 hours to obtain polishing particles.

As the organic silicon compound, TEOS (tetraethoxysilane) was applied, the first organic solvent and the second organic solvent were applied as ethanol and isopropyl alcohol, respectively, and ammonia was applied as the catalyst.

Preparation Example 2: Polishing particles were manufactured under the same conditions as in Preparation Example 1, except that in the first polishing particle preparation composition, 4.5 parts by weight of the organic silicon compound and 45.75 parts by weight of the first organic solvent were applied, and in the second polishing particle preparation composition, 3 parts by weight of water and 45.75 parts by weight of the second organic solvent were applied.

Preparation Example 3: Polishing particles were manufactured under the same conditions as in Preparation Example 1, except that in the first polishing particle preparation composition, 4.5 parts by weight of the organic silicon compound and 43.25 parts by weight of the first organic solvent were applied, and in the second polishing particle preparation composition, 8 parts by weight of water and 43.25 parts by weight of the second organic solvent were applied.

The process conditions for each preparation example are described in Table 1 below.

**Preparation Example: Manufacture of Polishing Composition**

Example 1: Into ultrapure water serving as a solvent, 8 wt% of the polishing particles according to Preparation Example 1, 0.4 wt% of citric acid, 0.2 wt% of benzotriazole, 0.2 wt% of polyethylene glycol, and 0.2 wt% of hydrogen peroxide were introduced and mixed to prepare a polishing composition of a total of 100 wt%.

Comparative Example 1: A polishing composition of a total of 100 wt% was prepared under the same conditions as in Example 1, except that 16 wt% of the polishing particles according to Preparation Example 2 were applied as the polishing particles.

Comparative Example 2: A polishing composition of a total of 100 wt% was prepared under the same conditions as in Example 1, except that 8 wt% of the polishing particles according to Preparation Example 2 were applied as the polishing particles.

Comparative Example 3: A polishing composition of a total of 100 wt% was prepared under the same conditions as in Example 1, except that 8 wt% of the polishing particles according to Preparation Example 3 were applied as the polishing particles.

For each of the examples and comparative examples, the polishing particle content in the polishing composition, the D50 of the secondary particles of the polishing particles, the zeta potential, and the pH were applied as described in Table 1 below.

**Evaluation Example: Measurement of Surface Characteristics of Polishing Particles**

The Ap value, As value, BET specific surface area value, micropore specific volume, and average diameter of micropores of the polishing particles in each preparation example were measured using the surface area measurement equipment "TriStar II 3020" manufactured by Micromeritics.

For the measurement, after degassing the polishing particles at 250°C for 3 hours, the degassed polishing particles were introduced into the surface area measurement equipment, and the amount of nitrogen adsorbed into the polishing particles was measured while increasing the relative pressure (p/p°) from 0 to 1.0 at 77.3K, and the amount of nitrogen desorbed from the polishing particles was measured while decreasing the relative pressure from 1.0 to 0, thereby obtaining the nitrogen adsorption isotherm and nitrogen desorption isotherm of the polishing particles. From the nitrogen adsorption/desorption isotherms, the Ap value, As value, BET specific surface area value, micropore specific volume, and average diameter of micropores were calculated, and from the Ap value and As value, the Rps value was calculated.

The measurement and calculation results for each preparation example are described in Table 2 below.

**Evaluation Example: Measurement of Secondary Particle Size Distribution of Polishing Particles**

The secondary particle size distribution of the polishing particles in each preparation example was measured using the particle size analyzer "Zetasizer nano-ZS" manufactured by Malvern Panalytical.

The measurement results for each preparation example are described in Table 3 and FIG. 1 below.

**Evaluation Example: Measurement of Polishing Rate**

The polishing compositions of the respective examples and comparative examples were applied as slurry to measure the polishing rates with respect to a silicon oxide film, a barrier film including tantalum and tantalum nitride, and a copper film, each formed on a wafer having a diameter of 300 mm. For each thin film, the polishing rate was measured under the conditions of a polishing time of 60 seconds, a pressure of 2.2 psi, a carrier speed of 93 rpm, a platen speed of 87 rpm, and a slurry flow rate of 300 ml/min, and the polisher used was the AP-300 model manufactured by CTS.

Subsequently, based on the measured polishing rate values, the $PI_S$ value according to the above Formula 2-1, the $PI_T$ value according to the above Formula 2-2, and the $PI_C$ value according to the above Formula 2-3 were calculated.

The measured values and calculated values for each of the examples and comparative examples are described in Table 4 below.

**Evaluation Example: Roughness Measurement of Polished Surface**

The polishing compositions of the respective examples and comparative examples were applied as slurry to measure the polishing rate of the copper film formed on a wafer having a diameter of 300 mm. For each thin film, the polishing rate was measured under the conditions of a polishing time of 60 seconds, a pressure of 2.2 psi, a carrier speed of 93 rpm, a platen speed of 87 rpm, and a slurry flow rate of 300 ml/min, and the polisher used was the AP-300 model manufactured by CTS.

Thereafter, the arithmetic mean roughness (Ra) according to ISO 4287 of the surface of the copper film polished by the polishing compositions of the respective examples and comparative examples was measured with an atomic force microscope (AFM), Park XE-100 model, manufactured by Park Systems.

The measured values for each example and comparative example are described in Table 5 below.

**Evaluation Example: Measurement of Defect Occurrence Frequency on Polished Surface**

The polishing compositions of the respective examples and comparative examples were applied as slurry to polish the surface of a $SiO_2$ wafer. The polishing conditions were applied in the same manner as those used in the polishing rate measurement evaluation described above.

The number of defects formed on the surface of the polished $SiO_2$ wafer was measured using the wafer defect detector, model AIT-XP+, manufactured by KLA Tencor.

Subsequently, the polishing compositions of the respective examples and comparative examples were applied as slurry to polish the surface of a $SiO_2$ wafer on which a copper pattern was formed. The measurement conditions were applied in the same manner as those used in the polishing rate measurement evaluation described above.

The number of defects formed on the surface of the polished patterned wafer was measured using the wafer defect detector, model AIT-XP+, manufactured by KLA Tencor.

The measurement results for each example and comparative example are described in Table 5 below.

**Evaluation Example: Evaluation of Dishing of Copper Wiring**

The polishing compositions of the respective examples and comparative examples were applied as slurry to polish a first patterned wafer having a diameter of 300 mm. The first patterned wafer was formed such that, on an $SiO_2$ film in which a copper pattern with a line width of 1 $\mu$m was formed, a barrier film having a thickness of 160 nm including tantalum and tantalum nitride was formed. The polishing conditions were applied in the same manner as those used in the polishing rate measurement evaluation described above. After polishing, the dishing values of the copper wiring were measured by AFM at a center portion located at the center of the substrate surface, an edge portion located at the edge of the substrate surface, and a middle portion located at the midpoint of a line connecting the centers of the center portion and the edge portion.

Subsequently, the polishing compositions of the respective examples and comparative examples were applied as slurry to polish a second patterned wafer. The second patterned wafer was formed such that, on an $SiO_2$ film in which a copper pattern with a line width of 10 $\mu$m was formed, a barrier film having a thickness of 400 nm including tantalum and tantalum nitride was formed. The polishing conditions were applied in the same manner as those used in the polishing rate measurement evaluation described above. After polishing, the dishing values of the copper wiring were measured by AFM from the polished substrate surface.

The measurement results for each example and comparative example are described in Table 6 below.

[Table 1]

| Classification | First Polishing Particle Preparation Composition | | Second Polishing Particle Preparation Composition | | | Reaction Temperature (°C) | Reaction time (hour) |
|---|---|---|---|---|---|---|---|
| | TEOS (parts by weight) | Ethanol (parts by weight) | Water (parts by weight) | Ammonia (parts by weight) | Isopropyl alcohol (parts by weight) | | |
| Preparation Example 1 | 15 | 41 | 2 | 1 | 41 | 45 | 5 |
| Preparation Example 2 | 4.5 | 45.75 | 3 | 1 | 45.75 | 45 | 5 |
| Preparation Example 3 | 4.5 | 43.25 | 8 | 1 | 43.25 | 45 | 5 |

[Table 2]

| | Polishing Particle Content (wt%) | $D_{50}$(nm) | Zeta Potential (mV) | pH |
|---|---|---|---|---|
| Example 1 | 8 | 76 | -48 | 10.4 |
| Comparative Example 1 | 16 | 80 | -55 | 10.4 |
| Comparative Example 2 | 8 | 80 | -55 | 10.5 |
| Comparative Example 3 | 8 | 85 | -54 | 10.4 |

[Table 3]

| | Rps | Ap($m^2$/g) | As($m^2$/g) | BET Specific Surface Area ($m^2$/g) | Micropore Specific Volume ($cm^3$/g) | Average Diameter of Micropores (nm) |
|---|---|---|---|---|---|---|
| Preparation Example 1 | 1.1566 | 28.2603 | 24.4349 | 52.6952 | 0.0136 | 24.8160 |
| Preparation Example 2 | 0.2561 | 9.3459 | 36.4962 | 45.8421 | 0.0044 | 13.7418 |
| Preparation Example 3 | 0.2997 | 24.2554 | 80.9398 | 105.1952 | 0.0103 | 10.2189 |

[Table 4]

| Diameter of Secondary Particles (nm) | Intensity | | |
|---|---|---|---|
| | Preparation Example 1 | Preparation Example 2 | Preparation Example 3 |
| 0.4 | 0 | 0 | 0 |
| 0.463 | 0 | 0 | 0 |
| 0.536 | 0 | 0 | 0 |
| 0.621 | 0 | 0 | 0 |
| 0.719 | 0 | 0 | 0 |
| 0.833 | 0 | 0 | 0 |

(continued)

| Diameter of Secondary Particles (nm) | Intensity | | |
|---|---|---|---|
| | Preparation Example 1 | Preparation Example 2 | Preparation Example 3 |
| 0.965 | 0 | 0 | 0 |
| 1.12 | 0 | 0 | 0 |
| 1.29 | 0 | 0 | 0 |
| 1.5 | 0 | 0 | 0 |
| 1.74 | 0 | 0 | 0 |
| 2.01 | 0 | 0 | 0 |
| 2.33 | 0 | 0 | 0 |
| 2.7 | 0 | 0 | 0 |
| 3.12 | 0 | 0 | 0 |
| 3.62 | 0 | 0 | 0 |
| 4.19 | 0 | 0 | 0 |
| 4.85 | 0 | 0 | 0 |
| 5.61 | 0 | 0 | 0 |
| 6.5 | 0 | 0 | 0 |
| 7.53 | 0 | 0 | 0 |
| 8.72 | 0 | 0 | 0 |
| 10.1 | 0 | 0 | 0 |
| 11.7 | 0 | 0 | 0 |
| 13.5 | 0 | 0 | 0 |
| 15.7 | 0 | 0 | 0 |
| 18.2 | 0 | 0 | 0 |
| 21 | 0 | 0 | 0 |
| 24.4 | 0 | 0 | 0 |
| 28.2 | 0 | 0 | 0 |
| 32.7 | 0 | 0 | 0 |
| 37.8 | 1.63 | 0 | 0 |
| 43.8 | 5.74 | 0 | 0 |
| 50.7 | 11.1 | 1.92 | 1.89 |
| 58.8 | 15.8 | 9.23 | 7.93 |
| 68.1 | 18.3 | 18.1 | 15.4 |
| 78.8 | 17.7 | 23.4 | 20.7 |
| 91.3 | 14.4 | 22.5 | 21.4 |
| 106 | 9.5 | 16 | 17.5 |
| 122 | 4.6 | 7.5 | 10.7 |
| 142 | 1.21 | 1.38 | 4.13 |
| 164 | 0 | 0 | 0.324 |
| 190 | 0 | 0 | 0 |
| 220 | 0 | 0 | 0 |

(continued)

| Diameter of Secondary Particles (nm) | Intensity | | |
|---|---|---|---|
| | Preparation Example 1 | Preparation Example 2 | Preparation Example 3 |
| 255 | 0 | 0 | 0 |
| 295 | 0 | 0 | 0 |
| 342 | 0 | 0 | 0 |
| 396 | 0 | 0 | 0 |
| 459 | 0 | 0 | 0 |
| 531 | 0 | 0 | 0 |
| 615 | 0 | 0 | 0 |
| 712 | 0 | 0 | 0 |
| 825 | 0 | 0 | 0 |
| 955 | 0 | 0 | 0 |
| 1110 | 0 | 0 | 0 |
| 1280 | 0 | 0 | 0 |
| 1480 | 0 | 0 | 0 |
| 1720 | 0 | 0 | 0 |
| 1990 | 0 | 0 | 0 |
| 2300 | 0 | 0 | 0 |
| 2670 | 0 | 0 | 0 |
| 3090 | 0 | 0 | 0 |
| 3580 | 0 | 0 | 0 |
| 4150 | 0 | 0 | 0 |
| 4800 | 0 | 0 | 0 |
| 5560 | 0 | 0 | 0 |
| 6440 | 0 | 0 | 0 |
| 7460 | 0 | 0 | 0 |
| 8630 | 0 | 0 | 0 |

[Table 5]

| | Polishing rate for silicon oxide film (Å/min) | $PI_S$ (Å/(min·wt%)) | Polishing rate for barrier film (Å/min) | $PI_T$ (Å/(min·wt%)) | Polishing rate for copper film (Å/min) | PIc (Å/(min·wt%)) |
|---|---|---|---|---|---|---|
| Example 1 | 1899 | 237.38 | 858 | 107.25 | 1178 | 147.25 |
| Comparative Example 1 | 1834 | 114.625 | 758 | 47.375 | 1364 | 85.25 |
| Comparative Example 2 | 1321 | 165.125 | 552 | 69 | 831 | 103.875 |
| Comparative Example 3 | 1602 | 200.25 | 851 | 106.375 | 1624 | 203 |

[Table 6]

| | Ra value (Å) of copper film after polishing | Number of defects (pcs) on SiO$_2$ wafer surface after polishing | Number of defects (pcs) on patterned wafer surface after polishing |
|---|---|---|---|
| Example 1 | 3.73 | 611 | 473 |
| Comparative Example 1 | 5.99 | 1343 | 1581 |
| Comparative Example 2 | 6.39 | 877 | 598 |
| Comparative Example 3 | 4.82 | 1246 | 1105 |

[Table 7]

| | Center part | | Middle part | | Edge part | |
|---|---|---|---|---|---|---|
| | Dishing value of copper wiring with width 1 μm (Å) | Dishing value of copper wiring with width 10 μm (Å) | Dishing value of copper wiring with width 1 μm (Å) | Dishing value of copper wiring with width 10 μm (Å) | Dishing value of copper wiring with width 1 μm (Å) | Dishing value of copper wiring with width 10 μm (Å) |
| Example 1 | 3 | 32 | 6 | 37 | 14 | 68 |
| Comparative Example 1 | 7 | 37 | 9 | 44 | 16 | 73 |
| Comparative Example 2 | 5 | 29 | 8 | 32 | 13 | 56 |
| Comparative Example 3 | 9 | 39 | 10 | 51 | 24 | 91 |

In Table 5, Example 1 exhibited higher PIS and PIT values compared to the Comparative Examples. It is considered that this is because the irregular shape of the polishing particles of Example 1 contributes to an improvement in the polishing rate of the polishing composition.

In Table 6, Example 1 exhibited a lower Ra value compared to the Comparative Examples. This means that Example 1 may form a smoother polished surface compared to the Comparative Examples when polishing a copper film.

In the number of defects on the surface of a SiO$_2$ wafer after polishing and the number of defects on the surface of a patterned wafer, Example 1 exhibited a lower number of defects compared to the Comparative Examples. It is considered that this is because Example 1 includes a smaller amount of polishing particles having a large diameter compared to the other Comparative Examples, resulting in a lower frequency of scratches generated on the polished surface by the polishing particles.

In particular, the fact that Example 1 exhibited a significantly lower number of defects compared to Comparative Example 1 is considered to be because the polishing composition of Example 1 includes a lower content of polishing particles compared to Comparative Example 1.

In the copper wiring dishing evaluation of Table 7, Example 1 exhibited similar or lower dishing values compared to the Comparative Examples.

Although preferred embodiments have been described in detail above, the scope of the present invention is not limited thereto, and various modifications and improved forms using the basic concept of the embodiments defined in the following claims by those skilled in the art also fall within the scope of the present invention.

Claims

1. A polishing composition for semiconductor process, comprising:
polishing particles,

wherein an Rps value, which is a ratio of a micropore specific surface area to an external specific surface area of the polishing particles of the following Formula 1, is 0.5 to 2;

[Formula 1]

$$Rps = \frac{Ap}{As}$$

in the Formula 1,
Ap is the micropore specific surface area of the polishing particles, and
As is the external specific surface area of the polishing particles.

2. The polishing composition for semiconductor process of claim 1,
   wherein the Ap value is 25 $m^2/g$ to 50 $m^2/g$.

3. The polishing composition for semiconductor process of claim 1,
   wherein the As value is 10 $m^2/g$ to 30 $m^2/g$.

4. The polishing composition for semiconductor process of claim 1,
   wherein a BET specific surface area of the polishing particles is 30 $m^2/g$ to 80 $m^2/g$.

5. The polishing composition for semiconductor process of claim 1,
   wherein a specific pore volume of the micropores of the polishing particles is 0.011 $cm^3/g$ to 0.2 $cm^3/g$.

6. The polishing composition for semiconductor process of claim 1,
   wherein an average diameter of the micropores of the polishing particles is 15 nm to 40 nm.

7. The polishing composition for semiconductor process of claim 1,
   wherein the polishing particles comprise secondary particles having a diameter of 120 nm or more in an amount of 10 wt% or less.

8. The polishing composition for semiconductor process of claim 1,
   wherein the polishing particles comprise secondary particles having a diameter of less than 50 nm in an amount of 10 wt% or less.

9. The polishing composition for semiconductor process of claim 1,
   wherein the polishing composition comprises the polishing particles in an amount of 4 wt% to 12 wt%.

10. The polishing composition for semiconductor process of claim 1,
    wherein the pH is 8 to 12.

11. A method for manufacturing a substrate, comprising:
    a process of polishing a substrate by applying, as a slurry, the polishing composition for semiconductor process of claim 1.

12.

    Polishing particles,
    wherein an Rps value, which is a ratio of a micropore specific surface area to an external specific surface area of the polishing particles of the following Formula 1, is 0.5 to 2;

[Formula 1]

$$Rps = \frac{Ap}{As}$$

in the Formula 1,
Ap is the micropore specific surface area of the polishing particles, and
As is the external specific surface area of the polishing particles.

**13.** The polishing particles of claim 12,
wherein the Ap value is 25 $m^2$/g to 50 $m^2$/g.

**14.** The polishing particles of claim 12,
wherein the As value is 10 $m^2$/g to 30 $m^2$/g.

**15.** The polishing particles of claim 12,
wherein a BET specific surface area is 30 $m^2$/g to 80 $m^2$/g.

**16.** The polishing particles of claim 12,
wherein a specific pore volume of the micropores is 0.011 $cm^3$/g to 0.2 $cm^3$/g.

**17.** The polishing particles of claim 12,
wherein an average diameter of the micropores is 15 nm to 40 nm.

[FIG. 1]

Diameter of secondary particles (nm)

## INTERNATIONAL SEARCH REPORT

| International application No. |
|---|
| **PCT/KR2024/005675** |

| A. | CLASSIFICATION OF SUBJECT MATTER |
|---|---|

**C09G 1/02**(2006.01)i; **C09K 3/14**(2006.01)i; **H01L 21/306**(2006.01)i

According to International Patent Classification (IPC) or to both national classification and IPC

| B. | FIELDS SEARCHED |
|---|---|

Minimum documentation searched (classification system followed by classification symbols)

C09G 1/02(2006.01); B24B 37/24(2012.01); B24D 3/00(2006.01); B82Y 40/00(2011.01); C01B 33/141(2006.01); C01B 33/145(2006.01); C01B 33/18(2006.01); C09K 3/14(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 연마입자(abrasive particle), 외부 비표면적(external surface area), 미세기공 비표면적(micropore surface area)

| C. | DOCUMENTS CONSIDERED TO BE RELEVANT |
|---|---|

| Category* | Citation of document, with indication, where appropriate, of the relevant passages | Relevant to claim No. |
|---|---|---|
| A | JP 2010-527879 A (EVONIK DEGUSSA GMBH) 19 August 2010 (2010-08-19)<br>See claims 1-17; and paragraph [0061]. | 1-17 |
| A | JP 2003-105324 A (RICOH CO., LTD.) 09 April 2003 (2003-04-09)<br>See entire document. | 1-17 |
| A | JP 2005-060217 A (FUSO CHEMICAL CO., LTD.) 10 March 2005 (2005-03-10)<br>See entire document. | 1-17 |
| A | KR 10-2007-0040428 A (KOREA INSTITUTE OF CERAMIC ENGINEERING & TECHNOLOGY) 17 April 2007 (2007-04-17)<br>See entire document. | 1-17 |
| A | KR 10-2022-0003604 A (FUJIFILM CORPORATION) 10 January 2022 (2022-01-10)<br>See entire document. | 1-17 |

☐ Further documents are listed in the continuation of Box C.　　☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **12 August 2024** | **13 August 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

International application No.

**PCT/KR2024/005675**

| Patent document cited in search report | | | Publication date (day/month/year) | Patent family member(s) | | | Publication date (day/month/year) |
|---|---|---|---|---|---|---|---|
| JP | 2010-527879 | A | 19 August 2010 | CN | 101679046 | A | 24 March 2010 |
| | | | | CN | 101679046 | B | 21 September 2011 |
| | | | | EP | 1997776 | A1 | 03 December 2008 |
| | | | | EP | 1997776 | B1 | 02 February 2011 |
| | | | | JP | 5340270 | B2 | 13 November 2013 |
| | | | | US | 2008-0290317 | A1 | 27 November 2008 |
| | | | | US | 7871589 | B2 | 18 January 2011 |
| | | | | WO | 2008-141868 | A1 | 27 November 2008 |
| JP | 2003-105324 | A | 09 April 2003 | JP | 3990936 | B2 | 17 October 2007 |
| JP | 2005-060217 | A | 10 March 2005 | JP | 4566645 | B2 | 20 October 2010 |
| KR | 10-2007-0040428 | A | 17 April 2007 | KR | 10-0759841 | B1 | 18 September 2007 |
| KR | 10-2022-0003604 | A | 10 January 2022 | JP | 2020-255603 | A1 | 24 December 2020 |
| | | | | JP | 7331103 | B2 | 22 August 2023 |
| | | | | US | 2022-0064490 | A1 | 03 March 2022 |
| | | | | WO | 2020-255603 | A1 | 24 December 2020 |

Form PCT/ISA/210 (patent family annex) (July 2022)

23

**REFERENCES CITED IN THE DESCRIPTION**

**Patent documents cited in the description**

- KR 1020230056015
- KR 1020170021320
- JP H11060232 B